# EUROPEAN PATENT APPLICATION

(11) **EP 3 073 534 A1**
(43) Date of publication of application: **28.09.2016**
(21) Application number: 14864622.7
(22) Date of filing: 19.11.2014
(51) Int. Cl.: H01L 31/0352

(54) **PHOTOELECTRIC CONVERSION LAYER AND PHOTOELECTRIC CONVERSION DEVICE**

(30) Priority: 19.11.2013 JP 2013238993; 27.11.2013 JP 2013245078; 29.11.2013 JP 2013247846
(71) Applicant: Kyocera Corporation, Kyoto-shi, Kyoto 612-8501 (JP)
(72) Inventor: KANAKURA,Atsushi, Kyoto-shi Kyoto 612-8501 (JP); FURUKUBO,Yuya, Kyoto-shi Kyoto 612-8501 (JP); NAKAYAMA,Toru, Kyoto-shi Kyoto 612-8501 (JP)
(74) Representative: Viering, Jentschura & Partner mbB Patent- und Rechtsanwälte
(86) International application number: PCT/JP2014/080648
(87) International publication number: WO 2015/076300

(57) **Abstract**

Provided are a quantum-dot layer having high absorbance and capable of enhancing power generation efficiency, and a solar cell. A photoelectric conversion layer 1 includes a quantum-dot-containing layer 5, the quantum-dot-containing layer 5 having a plurality of quantum dots 3 and wall sections 4 enclosing the quantum dots 3. In the cross section in the thickness direction of the quantum-dot-containing layer 5, three quantum dots 3, 3a aligned on a surface 7 of the quantum-dot-containing layer 5 so as to be adjacent to each other in the plane direction are extracted to draw straight line L so as to connect the surface 7 side ends of the two quantum dots 3 located on both sides, the quantum dot 3a located in the middle protrudes from the straight line to the surface 7 side by an amount equal to at least half the diameter of the quantum dot 3a located in the middle. This makes it possible to obtain the photoelectric conversion layer 1 that has high absorbance in an optical sensing layer 17 and has high power generation efficiency and a photoelectric conversion device including the same.

## Description

### TECHNICAL FIELD

The present invention relates to a photoelectric conversion layer and a photoelectric conversion device.

### BACKGROUND ART

Solar cells have been actively developed which are energy- and resources-saving and are clean energy sources. The solar cells are electric power devices that use a photovoltaic effect to directly convert optical energy to electric power. As such solar cells, an organic thin-film solar cell, a dye sensitized solar cell, and a multi-junction solar cell have been studied.

In particular, as a next-generation solar cell that theoretically enables a conversion efficiency of 60% or more, a solar cell including quantum dots (nanoparticles) (hereinafter, referred to as a quantum dot solar cell) is drawing attention. Hereinafter, the solar cell is sometimes referred to as a photoelectric conversion device.

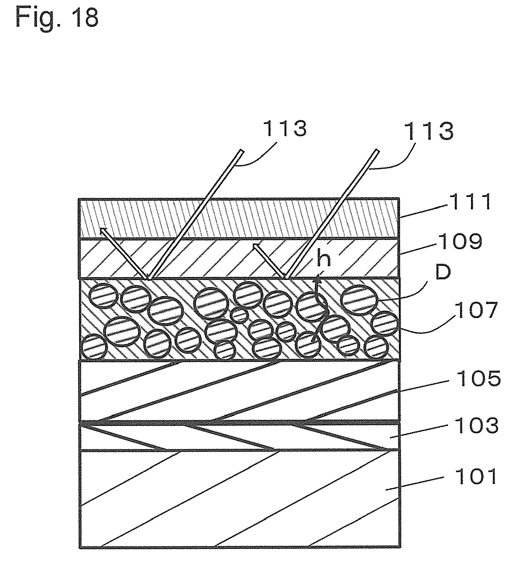

Fig. 18 is a cross-sectional schematic diagram illustrating an example of a conventional quantum dot solar cell disclosed in Patent Document 1. In Fig. 18, the conventional quantum dot solar cell includes a substrate 101, a p-side electrode 103, a p-type semiconductor layer 105, a photoelectric conversion layer 107 having quantum dots D, an n-type semiconductor layer 109, and an n-side electrode 111. In the conventional quantum dot solar cell illustrated in Fig. 18, the photoelectric conversion layer 107 having dispersed quantum dots D and the n-type semiconductor layer 109 are formed on the upper face side of the p-type semiconductor layer 105 in that order. When seen in cross-section view, both the photoelectric conversion layer 107 and the n-type semiconductor layer 109 have a plate shape with a substantially uniform thickness, and are arranged in parallel with the surface of the n-type semiconductor layer 105.

### PRIOR ART DOCUMENT

### PATENT DOCUMENTS

Patent Document 1: Japanese Unexamined Patent Publication No. 2010-206004

### SUMMARY OF THE INVENTION

### PROBLEM TO BE SOLVED BY THE INVENTION

When as illustrated in Fig. 18, the photoelectric conversion layer 107 has a substantially uniform thickness in the plane direction and the n-type semiconductor layer 109 is arranged so as to be substantially parallel with the photoelectric conversion layer 107, light 113, which passes through the n-type semiconductor layer 109 on the incidence light side, is likely to be reflected near the surface of the photoelectric conversion layer 107, resulting in difficulty in increasing absorbance. This makes it difficult to increase the number of carriers excided in quantum dots D (halls h in Fig. 18), resulting in reduction in the amount of electric charge taken out as an electric current, so that it is difficult to enhance power generation efficiency.

The present invention has been made in view of the above problems, and provides a photoelectric conversion layer that has high absorbance and is capable of enhancing power generation efficiency and a photoelectric conversion device including the same.

### MEANS FOR SOLVING THE PROBLEMS

A photoelectric conversion layer of the present invention includes a quantum-dot-containing layer, the quantum-dot-containing layer having a plurality of quantum dots and wall sections enclosing the quantum dots, wherein in the cross section in the thickness direction of the quantum-dot-containing layer, the quantum dots are aligned along a surface of the quantum-dot-containing layer so as to be adjacent to each other, and when three quantum dots adjacent to each other are extracted to draw a straight line so as to connect the surface side ends of the two quantum dots located on both sides, the quantum dot located in the middle protrudes from the straight line to the surface side by an amount equal to at least half the diameter of the quantum dot located in the middle, the quantum dot located in the middle being a protrusion quantum dot.

A photoelectric conversion device of the present invention includes an optical sensing layer having the photoelectric conversion layer.

### EFFECT OF THE INVENTION

According to the present invention, it is possible to obtain the photoelectric conversion layer that has high absorbance and is capable of enhancing power generation efficiency and the photoelectric conversion device including the same.

### BRIEF DESCRIPTION OF DRAWINGS

Fig. 1(a) is a cross-sectional schematic diagram illustrating a photoelectric conversion layer of a first embodiment, and Fig. 1(b) is a partial enlarged view on the surface side in Fig. 1(a).
Fig. 2 is a planar schematic diagram partially illustrating the photoelectric conversion layer of the first embodiment, seen in planar view from the incidence light side.
Fig. 3 is a cross-sectional schematic diagram illustrating the photoelectric conversion layer of a second embodiment, the photoelectric conversion layer including composite particles having a core-shell structure.
Fig. 4 is a cross-sectional schematic diagram illustrating a photoelectric conversion device of a first embodiment.
Fig. 5 is a cross-sectional schematic diagram illustrating a photoelectric conversion device of a second embodiment.
Fig. 6(a) is a cross-sectional schematic diagram illustrating a photoelectric conversion layer of a third embodiment, and Fig. 6(b) is a schematic diagram representing a state where the van der Waals force acts between quantum dots.
Fig. 7 is a cross-sectional schematic diagram illustrating the photoelectric conversion layer of a fourth embodiment, in which a quantum-dot-containing layer includes an upper quantum-dot-containing layer, a middle quantum-dot-containing layer, and a lower quantum-dot-containing layer arranged in the thickness direction thereof, the upper quantum-dot-containing layer and the lower quantum-dot-containing layer having a smaller average particle diameter of the composite particles than the middle quantum-dot-containing layer.
Fig. 8 is a cross-sectional schematic diagram illustrating the photoelectric conversion layer of a fifth embodiment.
Fig. 9 is a cross-sectional schematic diagram illustrating a photoelectric conversion device of a third embodiment.
Fig. 10 is a cross-sectional schematic diagram partially illustrating the vicinity of the interface between a photoelectric conversion layer and a current collection layer.
Fig. 11 is a cross-sectional schematic diagram illustrating the current collection layer, the current collection layer having a chevron-shaped cross section in the thickness direction thereof.
Fig. 12 is a schematic diagram illustrating the current collection layer, seen in planar view from the incidence light side.
Fig. 13 is a cross-sectional schematic diagram illustrating current collection layers, the current collection layers sandwiching the photoelectric conversion layer therebetween.
Fig. 14 is a cross-sectional schematic diagram illustrating a photoelectric conversion device of a fourth embodiment, in which the photoelectric conversion layer is arranged between two current collection layers.
Fig. 15 is a cross-sectional schematic diagram illustrating a photoelectric conversion device of a fifth embodiment, in which the photoelectric conversion layer arranged between two current collection layers includes a p-type semiconductor layer and n-type semiconductor layer arranged below and above a photoelectric conversion layer including the quantum dots.
Fig. 16 is a cross-sectional schematic diagram illustrating a photoelectric conversion device of a sixth embodiment, in which the photoelectric conversion layer is sandwiched between a joining layer having concave-convex portions and the n-side electrode having concave-convex portions.
Fig. 17 is a cross-sectional schematic diagram illustrating a quantum dot of another embodiment.
Fig. 18 is a cross-sectional schematic diagram illustrating a conventional quantum dot solar cell.

### EMBODIMENTS FOR CARRYING OUT THE INVENTION

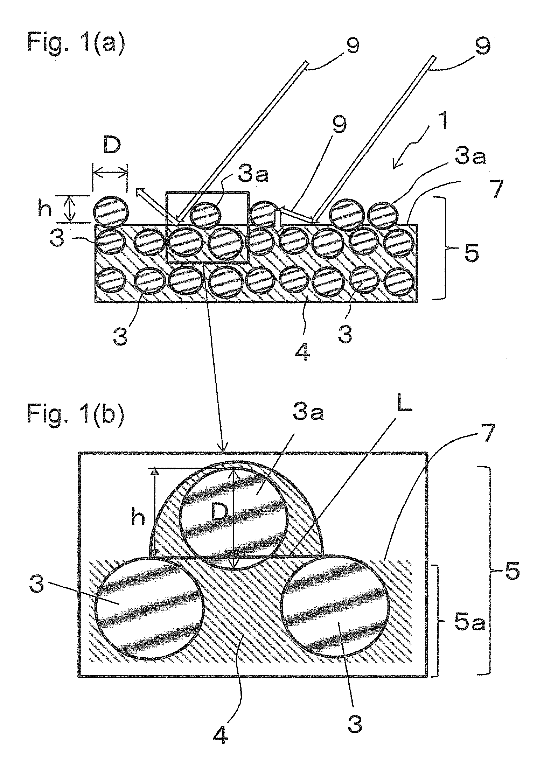

Fig. 1(a) is a cross-sectional schematic diagram illustrating a photoelectric conversion layer of a first embodiment, and Fig. 1(b) is a partial enlarged view on the surface side in Fig. 1(a). A photoelectric conversion layer 1 of the first embodiment includes a quantum-dot-containing layer 5, the quantum-dot-containing layer 5 having a plurality of quantum dots 3 and wall sections 4 (potential wall layers) enclosing the quantum dots 3. Here, the
quantum-dot-containing layer 5 has a surface on which the quantum dots 3 are flatly aligned. On the surface of the quantum-dot-containing layer 5, the quantum dots 3 are bonded or singly form convex portions.

In Fig. 1(b), in the photoelectric conversion layer 1 of the first embodiment, in the cross section in the thickness direction of the quantum-dot-containing layer 5, the quantum dots 3 are aligned along a surface 7 of the quantum-dot-containing layer 5 so as to be adjacent to each other in the plane direction. When three quantum dots 3 aligned along the surface 7 are extracted to draw straight line L so as to connect the surface 7 side ends of the two quantum dots 3, 3 located on both sides, the quantum dot 3 located in the middle protrudes from straight line L to the surface 7 side by an amount equal to at least half diameter D of the quantum dot 3 located in the middle, the quantum dot 3 located in the middle being a protrusion quantum dot 3a.

In other words, the quantum dot 3 between the two quantum dots 3 located on both sides, which protrudes from straight line L by an amount equal to at least half diameter D of the quantum dot 3 located on the both sides, is the protrusion quantum dot 3a. Hereinafter, the quantum dot 3, which is located in the middle between the two quantum dots 3, 3 located on both sides and protrudes by an amount equal to at least half diameter D of the quantum dot 3, is referred to as the protrusion quantum dot 3a. In addition, the portion of the quantum-dot-containing layer 5 except for the protrusion quantum dot 3a is sometimes referred to as a base portion 5a.

Typically, when light, such as solar light, is incident toward the photoelectric conversion layer, the light is reflected on the surface of the photoelectric conversion layer, resulting in difficulty in taking the incident light into the photoelectric conversion layer.

On the contrary, in the photoelectric conversion layer 1, when light 9, such as solar light, is incident toward the surface 7 of the photoelectric conversion layer 1 and is then reflected on the surface 7 of the quantum-dot-containing layer 5 as a main body, the light 9 (reflected light) is reflected again at the protrusion quantum dot 3a on the surface 7 of the quantum-dot-containing layer 5. This makes it possible to take part of the light 9 that is reflected once on the surface 7 of the quantum-dot-containing layer 5, into the photoelectric conversion layer 1 (the quantum-dot-containing layer 5), thereby increasing absorbance according to the light 9 reflected at the protrusion quantum dot 3a to be incident into the photoelectric conversion layer 1. As a result, power generation efficiency can be improved.

In addition, in the photoelectric conversion layer 1 of the first embodiment, a plurality of protrusion quantum dots 3a are preferably arranged on the surface 7 of the quantum-dot-containing layer 5 so as to be spaced from each other in the plane direction. When the protrusion quantum dots 3a are arranged on the surface 7 of the quantum-dot-containing layer 5 so as to be spaced from each other in the plane direction, it is possible to increase the surface area of the protrusion quantum dots 3a present on the surface 7 of the quantum-dot-containing layer 5. This makes it possible to reflect the light 9 reflected on the quantum-dot-containing layer 5, on the quantum-dot-containing layer 5 again with higher probability. In this case, preferably, the protrusion quantum dots 3a are present on the surface 7 of the quantum-dot-containing layer 5 so as to be isolated from each other without being in contact with each other.

Further, in the photoelectric conversion layer 1 of the first embodiment, the quantum dots 3 and the protrusion quantum dots 3a of the quantum-dot-containing layer 5 preferably have the same main component.

When the quantum dots 3 and the protrusion quantum dots 3a forming the quantum-dot-containing layer 5 have the same main component, when the quantum dots 3 and the protrusion quantum dots 3a of the quantum-dot-containing layer 5 are integrated with each other to structure the photoelectric conversion layer 1, the wavelengths and amplitudes of the wave functions of the carriers (electrons, halls) generated from the quantum dots 3, 3a become similar to each other, thus exhibiting coherent conductivity. As a result, it is possible to increase the amount of electric charge in the photoelectric conversion layer 1.

The presence state of the quantum dots 3 and the protrusion quantum dots 3a of the quantum-dot-containing layer 5 and the diameter of the protrusion quantum dots 3a are evaluated from the photograph of the cross section in the thickness direction of the photoelectric conversion layer 1. Specifically, the photograph of the cross section in the thickness direction of the quantum-dot-containing layer 5 is taken by means of a transmission electron microscope. As illustrated in Fig. 1(b), three quantum dots 3 aligned along the surface 7 of the quantum-dot-containing layer 5 so as to be adjacent to each other in the plane direction are extracted from the taken photograph. Then, straight line L is drawn so as to connect the surface 7 side ends (upper ends) of the two quantum dots 3, 3 located on both sides. Thereafter, the protrusion rate of the quantum dot 3 located in the middle from straight line L is determined.

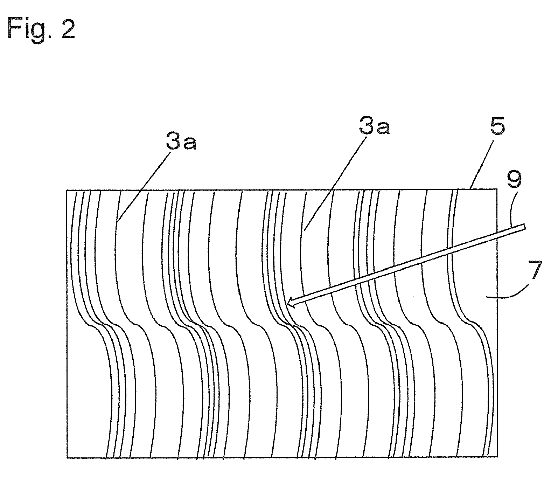

Fig. 2 is a planar schematic diagram partially illustrating the photoelectric conversion layer 1 of the first embodiment, seen in planar view from the incidence light side. In Fig. 2, one curve schematically represents the protrusion quantum dots 3a aligned on the surface 7 of the quantum-dot-containing layer 5, and the difference in the intervals between a plurality of curves represents that the intervals between the rows of the aligned protrusion quantum dots 3a are different from each other.

As illustrated in Fig. 2, the shape in which the protrusion quantum dots 3a are aligned on the surface 7 of the photoelectric conversion layer 1 may be a curved shape. When the shape in which the protrusion quantum dots 3a are aligned is a curved shape, the direction in which the protrusion quantum dots 3a are aligned is variously changed according to the place in the plane at seeing the quantum-dot-containing layer 5 in planar view from the incidence light side of the light 9. Thus, even when the incidence direction and the incidence angle of the solar light 9 are changed, the protrusion quantum dots 3a, in part, are in the direction perpendicular to the incidence direction of the solar light 9 (in the direction substantially perpendicular to the arrow of the solar light 9 in Fig. 2). As a result, even when the light 9 is incident into the quantum-dot-containing layer 5 from any direction, the reflected light 9 can be reflected again somewhere in the row in which the protrusion quantum dots 3a are aligned. This makes it possible to increase absorbance and the number of carriers (electrons, halls) excided thereby.

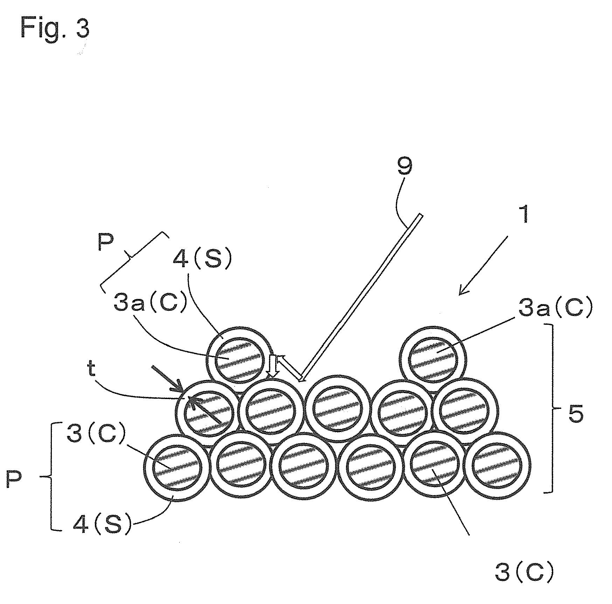

Fig. 3 is a cross-sectional schematic diagram illustrating the photoelectric conversion layer 1 of a second embodiment, the photoelectric conversion layer 1 including the quantum dots 3 having a core-shell structure.

As illustrated in Fig. 3, the photoelectric conversion layer 1 of the second embodiment includes core-shell composite particles P in which the quantum dots 3 are cores C and the wall sections 4 are shells S enclosing cores C in a donut-shape. When the quantum dots 3 and the wall sections 4 are formed of core-shell composite particles P, thicknesses t of the wall sections 4 (shells S) formed around the semiconductor particles as cores C can be substantially equal to each other. This makes it possible to make the intervals between the quantum dots 3 (cores C) arranged via the wall sections 4 more uniform. When thicknesses t of the wall sections 4 (shells S) enclosing the quantum dots 3 (cores C) become more equal, the carriers formed in the quantum dots 3 (cores C) easily conduct radially, not in the biased direction, even at changing the angle of the light 9 incident into the photoelectric conversion layer 1 (incidence angle). Thus, in a photoelectric conversion device (e.g., solar cell) described later, the carriers easily reach the semiconductor layers (p-type, n-type) adjacent to the photoelectric conversion layer 1. As a result, it is possible to improve the power generation efficiency of the photoelectric conversion device (solar cell).

In this case, as illustrated in Fig. 3, the protrusion quantum dots 3a may be formed of core-shell composite particles P. When the protrusion quantum dots 3a are formed of core-shell composite particles P, which have a substantially spherical shape, the reflection intensities all around the protrusion quantum dots 3a are equal to each other. This is less likely to cause a large difference in absorbance even when the solar light is emitted from a different direction. Thus, the photoelectric conversion device can have high output stability.

As the material of the photoelectric conversion layer 1, the elements of groups 12 to 16 in the periodic table (Zn, Ga, In, Tl, Si, Ge, Sn, P, As, Sb, S, Se, and Te) are preferably used singly or in combination.

When the photoelectric conversion layer 1 includes composite particles P having a core-shell structure, the shells (potential wall layers) structuring the quantum dots 3, 3a having a core-shell structure have a higher energy gap than the energy gap (1.1 eV) of silicon (Si) when used as the semiconductor material. The energy gap of the material of shells S at this time is preferably 1.3 eV to 3.0 eV. The energy gap of the wall sections 4 in a matrix shape, as illustrated in Fig. 1, is preferably in the same range.

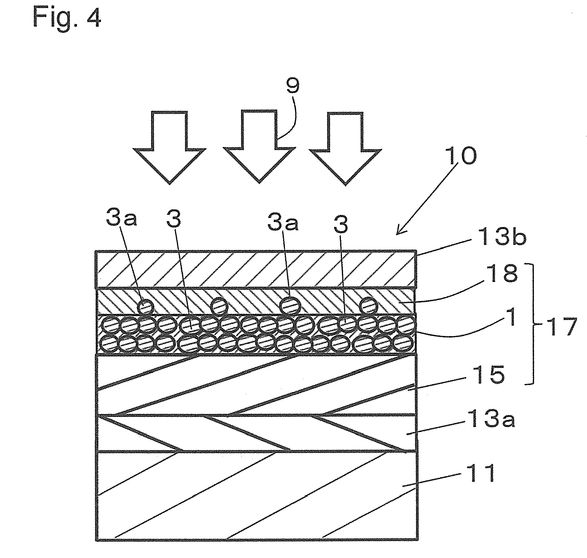

Fig. 4 is a cross-sectional schematic diagram illustrating a photoelectric conversion device of a first embodiment. A quantum dot photoelectric conversion device (solar cell) 10 illustrated in Fig. 4 is a solar cell having a so-called pin structure, and includes, on a substrate 11 on the lower layer side thereof, a p-side electrode 13a, a p-type semiconductor film as a first semiconductor layer 15, the photoelectric conversion layer 1, an n-type semiconductor film as a second semiconductor layer 18, and an n-side electrode 13b in that order. Here, the first semiconductor layer 15, the photoelectric conversion layer 1, and the second semiconductor layer 18 structure an optical sensing layer 17.

In the photoelectric conversion device 10 of the first embodiment, since the optical sensing layer 17 has the photoelectric conversion layer 1 including the protrusion quantum dots 3a on the surface 7 side of the quantum-dot-containing layer 5, the reflectivity of the light 9 is increased by the protrusion quantum dots 3 on the surface 7 of the quantum-dot-containing layer 5. As a result, it is possible to improve the power generation efficiency of the solar cell. In this case, the protrusion quantum dots 3a are preferably arranged so as to direct toward the incidence light side of the photoelectric conversion device 10. The protrusion quantum dots 3a, which are arranged so as to direct toward the incidence light side, are applied to the light 9 from the light source, such as the sun, thereby reflecting the light 9 in a larger amount. This makes it possible to increase the absorbance amount of the optical sensing layer 17.

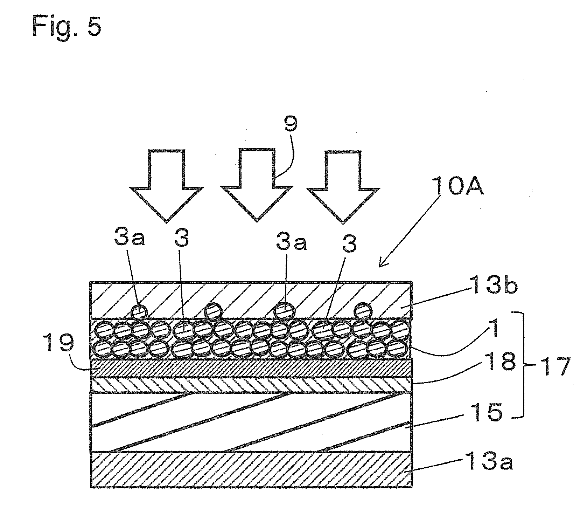

Fig. 5 is a cross-sectional schematic diagram illustrating a photoelectric conversion device of a second embodiment. A quantum dot photoelectric conversion device (solar cell) 10A illustrated in Fig. 5 has, on the p-side electrode 13a on the lower layer side thereof, the p-type semiconductor film (the first semiconductor layer 15), and the n-type semiconductor film (the second semiconductor layer 18), and also has, on the upper face side thereof, the photoelectric conversion layer 1, and the n-side electrode 13b. In this case, as illustrated in Fig. 5, a joining layer 19 having a current collection function and a buffering function is provided between the photoelectric conversion layer 1 and the n-type semiconductor film (the second semiconductor layer 18). In addition, for the p-type semiconductor film (the first semiconductor layer 15), a p-type semiconductor substrate may be used. In some cases, the joining layer 19 is not required to be provided.

In the photoelectric conversion device 10A of the second embodiment, as with the photoelectric conversion device 10 of the first embodiment, since the optical sensing layer 17 has the photoelectric conversion layer 1 including the protrusion quantum dots 3a on the surface 7 of the quantum-dot-containing layer 5, the reflectivity of the light 9 onto the quantum-dot-containing layer 5 side is increased by the protrusion quantum dots 3a on the surface 7 of the quantum-dot-containing layer 5. As a result, it is possible to improve the power generation efficiency of the photoelectric conversion device 10A. Also in this case, the protrusion quantum dots 3a are preferably arranged so as to direct toward the incidence light side of the photoelectric conversion device 10A.

When the p-side electrode 13a and the first semiconductor layer 15 are formed on the substrate, the substrate, which allows the light 9 to be incident from the p-type semiconductor film as the first semiconductor layer 15, is preferably light transmissive. For example, the substrate is preferably made of an inorganic material, such as glass or ceramic, or of an organic resin, such as polycarbonate and polyethylene terephthalate.

As the p-side electrode 13a, for example, aluminum (Al) is preferable. In addition to this, it is possible to use metal materials, such as nickel (Ni), cobalt (Co), platinum (Pt), silver (Ag), gold (Au), copper (Cu), molybdenum (Mo), titanium (Ti), and tantalum (Ta), or alloys thereof.

As the n-side electrode 13b, preferable is an electrode material having transmissivity that can transmit the solar light. It is preferable to apply e.g., tin oxide added with indium (indium tin oxide (ITO)). In addition to this, it is possible to use other conductive metal oxides, such as fluorine-doped tin oxide (FTO), indium oxide (IO), and tin oxide (SnO₂).

As the p-type semiconductor film as the first semiconductor layer 15, it is possible to use a semiconductor material doped with an element having a lower valence than the elements of groups 13 to 15 in the periodic table (e.g., Ga, In, Si, Ge, P, and As).

As the n-type semiconductor film as the second semiconductor layer 18, it is possible to use a semiconductor material doped with an element having a higher valence than the elements of groups 13 to 15 in the periodic table. By doping the elements having different valences into the semiconductor films, the first semiconductor layer 15 and the second semiconductor layer 18 can have conductive carriers.

As the joining layer 19, preferable are semiconductor materials, such as zinc oxide and zinc fluoride having a larger bandgap than the quantum dots 3, 3a.

A method for manufacturing the photoelectric conversion device 10A of the second embodiment will be described.

First, prepared is the substrate in which the n-type semiconductor film (the second semiconductor layer 18) is formed on the p-type semiconductor film (the first semiconductor layer 15).

Then, the p-side electrode 13a is formed on the surface of the substrate on the p-type semiconductor film (the first semiconductor layer 15) side. Then, the film mainly containing e.g., zinc oxide is formed as the joining layer 19 on the surface of the n-type semiconductor film (the second semiconductor layer 18). Subsequently, the photoelectric conversion layer 1 having the quantum dots 3, 3a is formed on the surface of the joining layer 19. Finally, the n-side electrode 13b is formed on the surface of the photoelectric conversion layer 1.

The quantum dots 3, 3a of the photoelectric conversion layer 1 can be obtained by precipitating a metal component by biomineralization from the solution of a metal compound containing the above semiconductor material. In this case, the metal compound mainly containing the above semiconductor material, a solvent, and ferritin are prepared and mixed by being heated, thereby synthesizing semiconductor particles. As the metal compound containing e.g., Si, for example, one selected from sodium silicate, hexafluorosilicate, and organic silane is used. As the ferritin, an apoferritin (derived from the spleen of a horse) solution is prepared, and the above compound containing Si is then added thereto.

As another method for obtaining the quantum dots 3, 3a, the compound containing the above element is thrown into a solution containing e.g., hydrogen fluoride, is stirred, and is irradiated with the light 9 having a constant wavelength.

The obtained semiconductor particles are dispersed in the solvent to prepare a slurry. As the solvent, preferable is an aqueous solvent, such as water, or a mixture of water and a water soluble organic solvent, such as acetonitrile.

The film of the quantum dots 3 not having the protrusion quantum dots 3a (corresponding to the base portion 5a in Fig. 1 (b)) is formed on the surface of the joining layer 19 with the semiconductor material by applying a physical thin-film forming method, such as sputtering, molecular beam epitaxy, or laser ablation.

To arrange the protrusion quantum dots 3a on the film of the base portion 5a, the previously made substrate formed with the base portion 5a is immersed into the slurry containing the semiconductor particles, and is then pulled up, thereby stacking the semiconductor particles (the protrusion quantum dots 3a) on the surface 7 of the base portion 5a.

The laminate in which the semiconductor particles that become the protrusion quantum dots 3a are arranged on the surface 7 of the base portion 5a is heated to a temperature of 300°C to 600°C in an inert gas, such as argon or nitrogen, or in a reducing gas containing hydrogen, to sinter the quantum-dot-containing layer 5. In this case, oxide films formed around the quantum dots 3 and the protrusion quantum dots 3a become the wall sections 4 (potential wall layers). This makes it possible to obtain the quantum-dot-containing layer 5 in which the protrusion quantum dots 3a are arranged on the base portion 5a.

To form the quantum-dot-containing layer 5 in which the protrusion quantum dots 3a are arranged so as to be spaced from each other in the plane direction, the density (content) of the semiconductor particles contained in the slurry is lowered, or vibration is given during film forming.

To form the quantum-dot-containing layer 5 in which both the quantum dots 3 and the protrusion quantum dots 3a are stacked so as to be formed of composite particles P having a core-shell structure, the substrate in which the n-type semiconductor film (the second semiconductor layer 18) is formed on the p-type semiconductor film (the first semiconductor layer 15) is immersed into the slurry containing the semiconductor particles and is pulled up. Then, the film of the semiconductor particles (the quantum dots 3) that becomes the base portion 5a for the quantum dots 3 is formed on the surface of the substrate, thereby being heated under the same conditions as the above method. The heating forms oxide films around the quantum dots 3 of the base portion 5a, which then become shells S.

The substrate formed with the base portion 5a is immersed again into the slurry containing the semiconductor particles, and is then pulled up to be heated. This forms the quantum-dot-containing layer 5 in which the protrusion quantum dots 3a are arranged on the surface 7 of the base portion 5a. The photoelectric conversion layer 1 including the quantum-dot-containing layer 5 forms the optical sensing layer 17 of the photoelectric conversion device 10.

The n-type semiconductor film formed as the second semiconductor layer 18 on the surface of the photoelectric conversion layer 1 is formed along the surface shape of the photoelectric conversion layer 1. For such film forming, as with the base portion 5a, a physical method, such as sputtering, molecular beam epitaxy, or laser ablation, is used. The physical method, such as sputtering, molecular beam epitaxy, or laser ablation, has the advantage that it is difficult to break the shape of the previously formed photoelectric conversion layer 1.

In the thus obtained photoelectric conversion device 10A that is the quantum dot solar cell, the optical sensing layer 17 includes the photoelectric conversion layer 1 in which the protrusion quantum dots 3a are arranged on the surface of the base portion 5a having a substantially flat surface. It is thus possible to increase the absorbance and the power generation efficiency of the optical sensing layer 17.

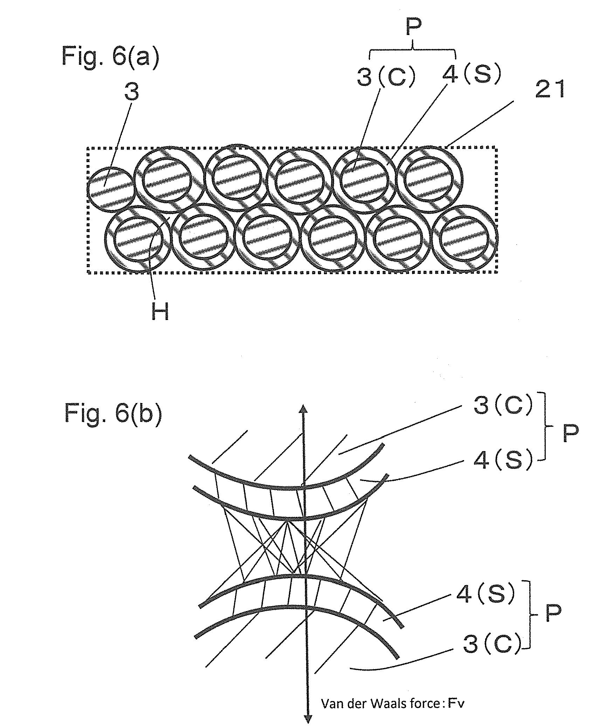

Fig. 6(a) is a cross-sectional schematic diagram illustrating a photoelectric conversion layer of a third embodiment, and Fig. 6(b) is a schematic diagram representing a state where the van der Waals force acts between composite particles P. Here, a photoelectric conversion layer 21 of the third embodiment includes composite particles P, but is not limited to this, and can also include the quantum dots 3 not having shells S.

As illustrated in Fig. 6 (a), the photoelectric conversion layer 21 of the third embodiment includes a stacking film in which a plurality of composite particles P in which the quantum dots 3 are cores C and the wall sections 4 enclosing the cores are shells S are bonded to each other by the van der Waals force (Fv).

In the photoelectric conversion layer 21 of the third embodiment, composite particles P are bonded to each other in such a manner that atom diffusion hardly occurs between adjacent composite particles P. Thus, there are almost no changes in composition and shape near the surfaces of individual composite particles P. This can prevent bonded composite particles P from being defected near the surfaces of composite particles P, and thus can maintain the energy gap (Eg) of composite particles P. As a result, high photoelectric conversion characteristic can be exerted.

Here, the van der Waals force is an attractive force acting on the neutral atoms or molecules having little electron charge. For composite particles P of this embodiment, the electric dipole (dipole moment) slightly generated in each composite particle P interacts with the electric dipoles of composite particles P generated therearound in the same manner.

When composite particles P of the photoelectric conversion layer 21 of the third embodiment are bonded to each other by the van der Waals force, the contours thereof can be found at observing the cross section of the photoelectric conversion layer 21 by means of an electron microscope, and most of the contours do not have a neck between adjacent composite particles P. In this case, in the region in which approximately 20 to 100 composite particles P are found, the percentage of portions determined to be a neck is 5% or less. In addition, when the strength (bonding force) of the film of the photoelectric conversion layer 1 including composite particles P is measured by macro-scratch, the critical load is 300 gf or more and 1000 gf or less. On the contrary, when a neck is formed between composite particles P, a linear grain boundary phase is not found between composite particles P, and composite particles P are partially connected to each other. This is the same for the photoelectric conversion layer 21 including, in part, quantum dots 3 not having shells S, in place of composite particles P.

As described above, composite particles P of the photoelectric conversion layer 21 of the third embodiment have a core-shell structure, and in this case, quantum dots 3 as cores C are preferably semiconductor particles having a bandgap (Eg) of 0.10 eV to 3.00 eV, and preferably mainly contain at least one element selected from the elements of groups 12, 13, 14, 15, and 16 in the periodic table. Specifically, it is preferable to use, for example, at least one semiconductor material selected from germanium (Ge), silicon (Si), gallium (Ga), indium (In), arsenic (As), antimony (Sb), lead (Pb), tellurium (Te), and selenium (Se). In addition, shells S (the wall sections 4) enclosing the quantum dots 3 (cores C) preferably have a bandgap 1.5 to 2.3 times the bandgap of the semiconductor particles of cores C.

Composite particles P of the photoelectric conversion layer 21 of the third embodiment are preferably a spherical body. When composite particles P are a spherical body, the thicknesses of the wall sections 4 formed around the quantum dots 3 can be substantially equal to each other. This can form the wave function having the same wavelength and amplitude in any direction of the quantum dots 3. As a result, the photoelectric conversion layer 21 can have less anisotropy in the conductive characteristic of the carriers (electrons, halls), and is thus less likely to depend on the irradiation direction of the light, thereby having high power gain. In this case, at least 90% of composite particles P of the photoelectric conversion layer 21 per unit volume preferably have the core-shell structure of composite particles P.

Here, whether composite particles P have a core-shell structure is determined in such a manner that composite particles P found in the cross section of the photoelectric conversion layer 21 are subjected to micro-structure observation by transmission electron microscope observation, structure analysis by electron diffraction provided in a transmission electron microscope, and change in composition by an element analyzer.

Composite particles P of the photoelectric conversion layer 21 of the third embodiment preferably have, e.g., a maximum diameter of 30 nm or less, an average particle diameter of 3 nm to 20 nm, and the variation in particle diameter within 10%. When the maximum diameter, the average particle diameter, and the variation in particle diameter of composite particles P are within the above ranges, the regular long-period structure of the carriers (electrons) is easily formed between composite particles P at stacking composite particles P to form the photoelectric conversion layer 21, thereby forming a continuous band structure. At this time, shells S preferably have an average thickness of 1 nm to 3 nm.

The photoelectric conversion layer 21 of the third embodiment preferably has void H between composite particles P. When the photoelectric conversion layer 21 is formed of composite particles P, the portion in which composite particles P are not in contact with each other is present near the portion in which composite particles P are in contact with each other, thereby forming void H between composite particles P. When void H is present between composite particles P, composite particles P of the photoelectric conversion layer 21 are bonded to each other by the van der Waals force that does not provide strong bond, such as covalent bond or ionic bond, and the frequency and area in which composite particles P are bonded to each other are reduced, thereby forming the photoelectric conversion layer 21 having low rigidity. As a result, the photoelectric conversion layer 21 is easily bent or flexible, so that for example, the photoelectric conversion device can be provided on a human body whose surface is less flat and on the surface of a structure having a curved surface.

Here, the arrangement, size (average particle diameter), and volume occupation rate of composite particles P of the photoelectric conversion layer 21 are determined from a photograph obtained by observing the cross section of the device having the photoelectric conversion layer 21 by means of a transmission electron microscope. The volume occupation rate may be replaced with the area occupation rate in the cross section of the photoelectric conversion layer 21.

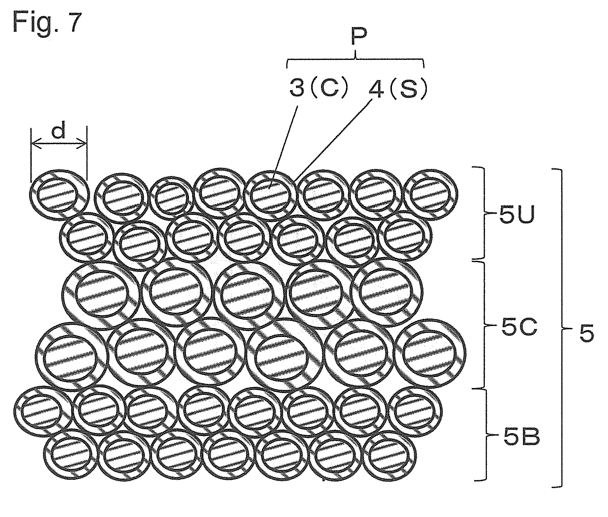

Fig. 7 is a cross-sectional schematic diagram illustrating the photoelectric conversion layer of a fourth embodiment, in which the quantum-dot-containing layer 5 includes an upper quantum-dot-containing layer 5, a middle quantum-dot-containing layer 5, and a lower quantum-dot-containing layer 5 arranged in the thickness direction thereof, the upper quantum-dot-containing layer 5 and the lower quantum-dot-containing layer 5 having a smaller average particle diameter of composite particles P than the middle quantum-dot-containing layer 5.

In the quantum-dot-containing layer 5 of the photoelectric conversion layer 21 of the fourth embodiment, composite particles P are preferably arranged so as to be different in the average particle diameter in the thickness direction. In this case, in particular, composite particles P are preferably arranged so as to be smaller in the thickness direction in an upper quantum-dot-containing layer 5U and a lower quantum-dot-containing layer 5B than in a middle quantum-dot-containing layer 5C.

When size (average particle diameter) d of composite particles P arranged in the quantum-dot-containing layer 5 is smaller in the thickness direction of the quantum-dot-containing layer 5 in the upper quantum-dot-containing layer 5U and the lower quantum-dot-containing layer 5B than in the middle quantum-dot-containing layer 5C, the quantum size effect of composite particles P can form the region in which the bandgap is modulated in the quantum-dot-containing layer 5. This makes it possible to use light having a wider wavelength. In this case, the quantum dots 3 preferably have a size difference of 0.5 nm or more and 1.0 nm or less between the middle quantum-dot-containing layer 5C, and the upper quantum-dot-containing layer 5U and the lower quantum-dot-containing layer 5B in the thickness direction of the quantum-dot-containing layer 5.

In this case, the quantum dots 3 arranged in the layers 5U, 5C, and 5B illustrated in Fig. 7 preferably have a particle diameter range in the layers within 2 nm, and the difference between the average particle diameters of the quantum dots 3 between the layers is preferably more than 2 nm. Here, substantially the same size means that the variation in the maximum diameter of the quantum dots 3 (σ/× : σ is the standard deviation, and × is the average value) is within 10% when the photoelectric conversion layer 21 is seen in cross-sectional view.

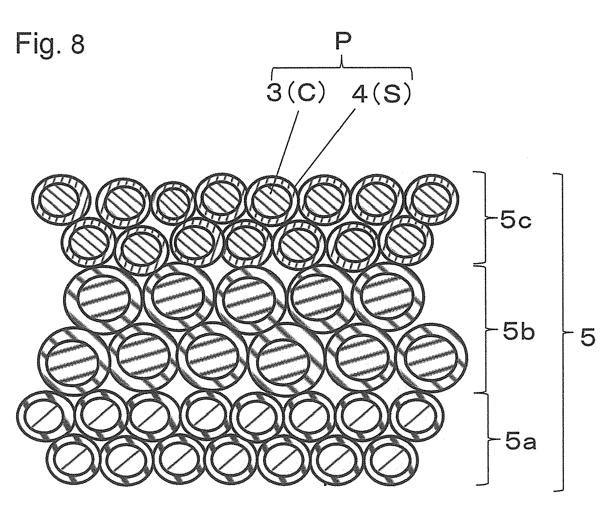

Fig. 8 is a cross-sectional schematic diagram illustrating the photoelectric conversion layer of a fifth embodiment. The quantum-dot-containing layer 5 of the photoelectric conversion layer 21 of the fifth embodiment includes a first quantum-dot-containing layer 5a, a second quantum-dot-containing layer 5b, and a third quantum-dot-containing layer 5c, which contain elements different valences. The first quantum-dot-containing layer 5a is of the p-type, the second quantum-dot-containing layer 5b is of i-type, and the third quantum-dot-containing layer 5c is of the n-type. In this case, the first quantum-dot-containing layer 5a of the p-type and the third quantum-dot-containing layer 5c of the n-type absorb light having a wavelength different from that of the second quantum-dot-containing layer 5b of the i-type. Thus, the photoelectric conversion device can cover the solar light spectrum in a wider wavelength range, and have high photoelectric conversion efficiency.

All of composite particles P of the first quantum-dot-containing layer 5a, the second quantum-dot-containing layer 5b, and the third quantum-dot-containing layer 5c are bonded to each other by the van der Waals force. This makes it possible to maintain the energy gas (Eg) of composite particles P for a long period, so that photoelectric conversion characteristic can be continuously high.

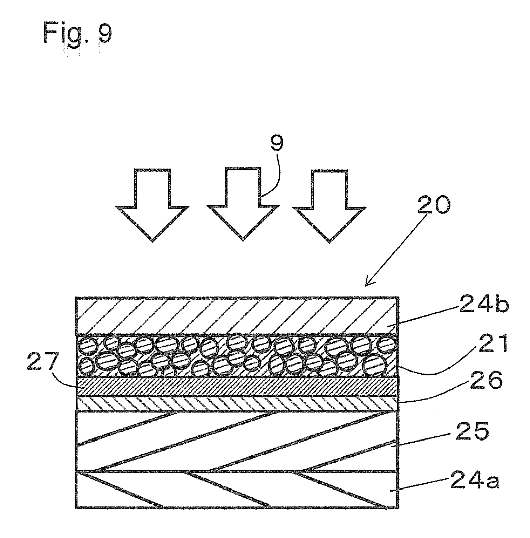

Fig. 9 is a cross-sectional schematic diagram illustrating a photoelectric conversion device of a third embodiment. A photoelectric conversion device (solar cell) 20 illustrated in Fig. 9 has the same structure as the photoelectric conversion device 10A of the second embodiment illustrated in Fig. 5. That is, the photoelectric conversion device 20 has, on a p-side electrode 24a on the lower layer side thereof, a p-type semiconductor film (a first semiconductor layer 25), and an n-type semiconductor film (a second semiconductor layer 26), and also has, on the upper side thereof, the photoelectric conversion layer 21, and an n-side electrode 24b. Also in this case, a joining layer 27 having a current collection function and a buffering function is provided between the photoelectric conversion layer 21 and the n-type semiconductor film (the second semiconductor layer 26). In some cases, the joining layer 27 is not required to be provided.

The photoelectric conversion device 20 of the third embodiment can obtain high photoelectric conversion characteristic based on the photoelectric conversion layer 21 of the third to fifth embodiments.

A method for manufacturing the photoelectric conversion device 20 of the third embodiment will be described.

First, prepared is the substrate in which the n-type semiconductor film (the second semiconductor layer 26) is formed on the p-type semiconductor film (the first semiconductor layer 25).

Then, the p-side electrode 24a is formed on the surface of the substrate on the p-type semiconductor film (the first semiconductor layer 25) side. Then, the film mainly containing e.g., zinc oxide is formed as the joining layer 27 on the surface of the n-type semiconductor film (the second semiconductor layer 26). Subsequently, the photoelectric conversion layer 21 having the quantum dots 3 and the wall sections 4 (the quantum-dot-containing layer 5) is formed on the surface of the joining layer 27. Thereafter, the n-side electrode 24b is formed on the surface of the photoelectric conversion layer 21.

The quantum dots 3 of the photoelectric conversion layer 21 can be obtained by precipitating a metal component by biomineralization from the solution of a metal compound containing the above semiconductor material. In this case, the metal compound mainly containing the above semiconductor material, a solvent, and ferritin are prepared and mixed by being heated, thereby synthesizing semiconductor particles. As the metal compound containing e.g., Si, for example, one selected from sodium silicate, hexafluorosilicate, and organic silane is used. As the ferritin, an apoferritin (derived from the spleen of a horse) solution is prepared, and the above compound containing Si is then added thereto.

As another method for obtaining the quantum dots 3, the compound containing the above element is thrown into a solution containing e.g., hydrogen fluoride, is stirred, and is irradiated with the light having a constant wavelength.

To form precursor particles that become composite particles P, at the time of using the manufacturing method by biomineralization, different metal components may be sequentially precipitated, or the previously obtained semiconductor particles that become the quantum dots 3 may be heated to form an oxide film containing the component of the quantum dots 3 on the surfaces of the quantum dots 3.

The formed precursor particles are dispersed in the solvent to prepare a slurry. As the solvent, preferable is a water solvent, such as water, or a mixture of water and an aqueous soluble organic solvent, such as acetonitrile.

To make the photoelectric conversion layer 21, the substrate (in which the p-side electrode 24a is formed on the surface of the substrate on the p-type semiconductor film (the first semiconductor layer 25) side, and the joining layer 27 is formed on the surface of the n-type semiconductor film (the second semiconductor layer 26)) is immersed into the slurry containing the precursor particles, and is then pulled up, thereby stacking the precursor particles on the surface of the joining layer 27 formed on the substrate.

The laminate in which the precursor particles are stacked on the surface of the joining layer 27 is heated at a temperature of room temperature to 300°C in an inert gas, such as argon or nitrogen, or in a reducing gas containing hydrogen. This operation may be performed under reduced pressure. Such a process removes impurities, such as the solution, from the films of the precursor particles. At the same time, it is possible to obtain the film that becomes the photoelectric conversion layer 21 in which composite particles P are bonded to each other by the van der Waals force from the surface tension of the precursor particles. The thus obtained composite particles P, which are thermally treated at a temperature to the extent to evaporate the solution, a neck is hardly found between composite particles P. In addition, composite particles P have clear boundaries between the quantum dots 3 and the wall sections 4.

When composite particles P are a spherical body having an aspect ratio of 1.2 or less, void H is formed between the portions in which composite particles P are not in contact with each other.

To form the photoelectric conversion layer 21 in which composite particles P are arranged so as to be different in size in the thickness direction of the stacking film, small and large composite particles P different in size (average particle diameter) are prepared. Then, small-diameter composite particles P, large-diameter composite particles P, and small-diameter composite particles P are sequentially attached onto the surface of the substrate.

In the photoelectric conversion device 20 that has the photoelectric conversion layer 21 including p-type composite particles P, i-type composite particles P, and n-type composite particles P in that order, which contain the elements having different valences, when the quantum dots 3 of the i-type composite particles P are formed of e.g., Si, a pentavalent element is doped into the Si particles to form the p-type quantum dots 3, and a trivalent element is doped into the Si particles to form the n-type quantum dots 3. Then, composite particles P including the quantum dots 3 are sequentially formed to form the laminate.

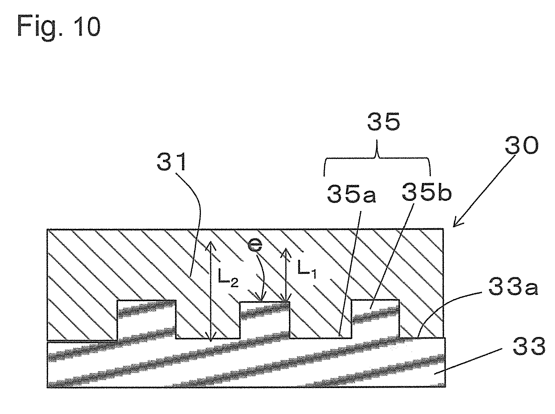

Fig. 10 is a cross-sectional schematic diagram partially illustrating the vicinity of the interface between a photoelectric conversion layer and a current collection layer. Fig. 10 illustrates only the vicinity of the interface between a photoelectric conversion layer 31 and a current collection layer 33. In this case, as with the photoelectric conversion device 10A of the second embodiment and the photoelectric conversion device 20 of the third embodiment, the p-side electrode or the n-side electrode is provided on the upper face side of the photoelectric conversion layer 31. In this case, the semiconductor layer having a component structure and polarity different from those of the photoelectric conversion layer 31 can be provided between the photoelectric conversion layer 31 and the electrode. Further, a plurality of photoelectric conversion layers 31 can be laminated with the current collection layer 33. Here, the current collection layer 33 is applied, not only to the p-side electrodes 13a and 24a and the n-side electrodes 13b, 24b, which are formed on the surfaces of the photoelectric conversion layers 1, 21, and 31, but also to members contributing to carrier collection, such as the joining layers 19, 27.

As the material of the current collection layer 33, it is preferable to use a semiconductor material having a higher bandgap than the semiconductor material of the quantum dots 3, 3a. When as the material of the current collection layer 33, the semiconductor material having a higher bandgap than the semiconductor material of the quantum dots 3, 3a is applied, the current collection layer 33 functions as a current collection member between the current collection layer 33 and the photoelectric conversion layer 31. Thus, even when a plurality of quantum-dot-containing layers 5 are laminated, it is possible to maintain the density of the movable carriers high. As such a semiconductor material, zinc oxide and zinc fluoride are preferable.

The structure illustrated in Fig. 10 is applied to e.g., the photoelectric conversion devices 10, 10A, 20 and 30 of the first to third embodiments. In this case, a surface 33a on the photoelectric conversion layer 31 side of the current collection layer 33 arranged on the lower layer side of the photoelectric conversion layer 31 has concave-convex portions 35 (hereinafter, sometimes referred to as concave portions 35a and convex portions 35b).

In Fig. 10, the concave portions 35a and the convex portions 35b are provided on the surface 33a of the current collection layer 33 in contact with the photoelectric conversion layer 31. Thus, the surface area of the surface 33a of the current collection layer 33 is larger than the projection face. This makes it possible to enhance the taking-out efficiency, from the current collection layer 33, of electrons e that are the carriers generated on the photoelectric conversion layer 31.

When the current collection layer 33 has the concave portions 35a and the convex portions 35b, distance L₁ from moving electron e to each convex portion 35b is shorter than distance L₂ from moving electron e to the bottom of each concave portion 35a on the surface 33a of the current collection layer 33, as illustrated in Fig. 10. This lowers the probability that electron e is bonded to the carrier (hall: h) having different polarity. As a result, the amount of electric charge taken out as an electric current can be prevented from being lowered, thereby making energy conversion efficiency higher.

In this case, the concave portions 35a and the convex portions 35b of the current collection layer 33, which are present on the surface of the photoelectric conversion layer 31, may be caused by the protrusions (convex portions) of the protrusion quantum dots 3a protruding onto the outermost surface of the quantum-dot-containing layer 5. In the concave-convex portions 35, the corners of the tops of the convex portions 35b and the bottoms of the concave portions 35a, which are acute, may be curved.

It is possible to determine, from the photograph of the cross section of the current collection layer 33 obtained by using an electron microscope, whether the surface 33a of the current collection layer 33 has the concave-convex portions 35. In this case, the current collection layer 33 has surface roughness (here, maximum difference Rz) of 10 nm or more.

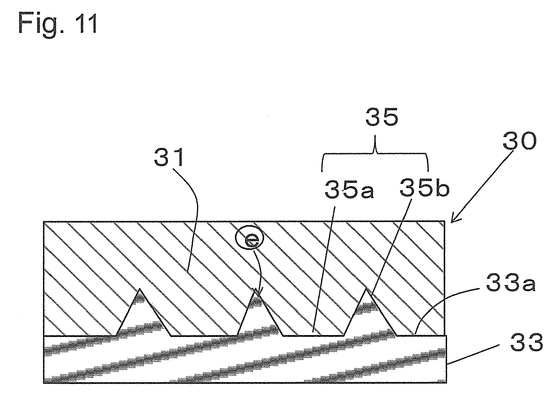

Fig. 11 is a cross-sectional schematic diagram illustrating the current collection layer 33, the current collection layer 33 having a chevron-shaped cross section in the thickness direction thereof. When the convex portions 35b formed on the surface 33a of the current collection layer 33 which has a chevron-shaped cross section, the convex portions 35b are acute at the ends thereof, as illustrated in Fig. 11. This allows electrons e as the carriers to be easily gathered onto the convex portions 35b, thereby enhancing the taking-out efficiency of electrons e from the current collection layer 33.

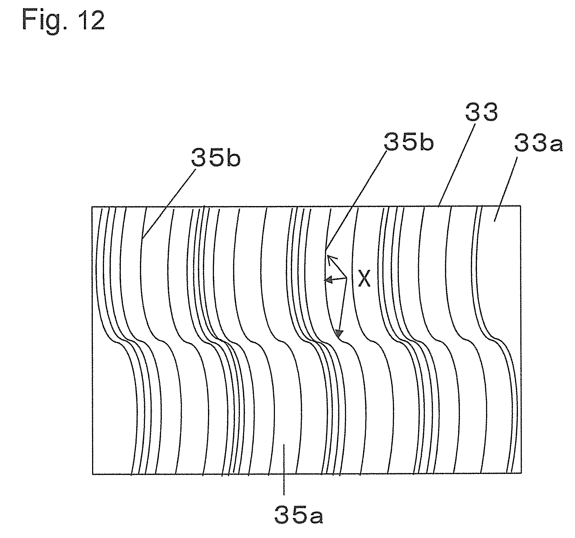

Fig. 12 is a schematic diagram partially illustrating the current collection layer 33, seen in planar view from the incidence light side. In Fig. 12, one curve 35b schematically represents a plurality of convex portions 35b aligned on the surface 33a of the current collection layer 33, and the difference in the intervals between a plurality of curves 35b represents that the intervals between the rows of the aligned convex portions 35b are different from each other.

As illustrated in Fig. 12, the convex portions 35b (or the concave portions 35a) are aligned in a curved shape on the surface 33a of the current collection layer 33. In this case, as indicated by arrows having different lengths from point X in three directions, the portions having different distances from a point in the photoelectric conversion layer 31 to the surface 33a of the current collection layer 33 are formed. Thus, even when the moving direction of the carriers, such as electrons e or halls h, generated in the photoelectric conversion layer 31 is deformed due to a defect in the photoelectric conversion layer 31, the carriers can quickly reach somewhere in the current collection layer 33, that is, the surface 33a to which the carriers move closer. As a result, it is possible to prevent the carriers generated in the photoelectric conversion layer 31 from being extinct, thereby increasing the amount of electric charge taken out. In Fig. 12, X is not on the surface 33a of the current collection layer 33, but in the photoelectric conversion layer 31 thereon.

In the photoelectric conversion device 30, the protrusion quantum dots 3a protruding from the quantum-dot-containing layer 5 preferably engage with the concave portions 35a of the current collection layer 33. When the protrusion quantum dots 3a of the quantum-dot-containing layer 5 are arranged so as to engage with the concave portions 35a of the current collection layer 33, the contact area of the quantum-dot-containing layer 5 of the photoelectric conversion layer 31 and the current collection layer 33 becomes larger. This allows the carriers to reach the current collection layer 33 from the photoelectric conversion layer 31 more easily. Thus, it is possible to further prevent the carriers from being extinct, thereby further increasing the amount of electric charge taken out.

A state where the concave-convex portions 35 of the current collection layer 33 are aligned in a curved shape when the current collection layer 33 is seen in planar view, and a state where the photoelectric conversion layer 31 is arranged so as to engage with the concave portions 35a of the current collection layer 33, are applied in the same manner to the current collection layer 33 having a chevron-shaped cross section illustrated in Fig. 11.

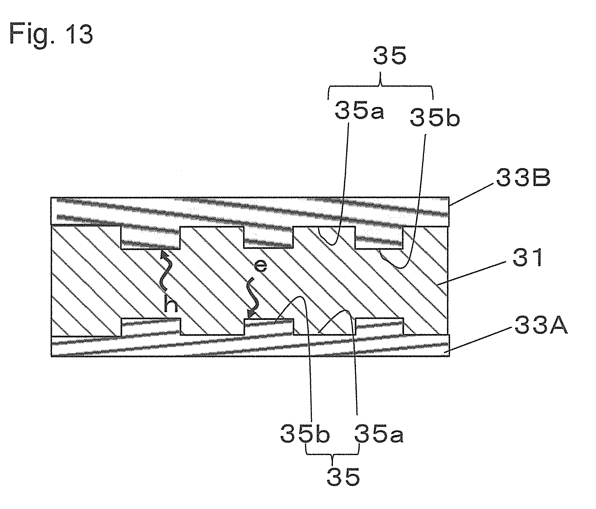

Fig. 13 is a cross-sectional schematic diagram illustrating current collection layers sandwiching the photoelectric conversion layer therebetween. In this case, two current collection layers 33 are preferably arranged so as to sandwich the photoelectric conversion layer 31. In other words, when the current collection layers 33 (a lower current collection layer 33A, an upper current collection layer 33B) are arranged on the lower and upper faces of the photoelectric conversion layer 31 so that the concave portions 35a and the convex portions 35b are directed toward the photoelectric conversion layer 31. This can simultaneously increase, on both faces of the photoelectric conversion layer 31, the probability that electrons e as carriers reach the current collection layer 33A and the probability that halls h as carriers reach the current collection layer 33B. Thus, energy conversion efficiency can be further enhanced.

To make the current collection layers 33A, 33B become electrodes arranged on the outermost layers of the photoelectric conversion layer 31, the following conductive materials are used.

For example, a material having transmissivity may be applied to the current collection layer 33B facing in the direction in which the solar light is incident. As the electrode material in this case, for example, tin oxide added with indium (indium tin oxide ITO)) is preferably applied. In addition to this, it is possible to use other conductive metal oxides, such as fluorine-doped tin oxide (FTO), indium oxide (IO), and tin oxide (SnO₂).

As the electrode material of the current collection layer 33A, for example, aluminum (Al) is preferable. In addition to this, preferable are metal materials, such as nickel (Ni), cobalt (Co), platinum (Pt), silver (Ag), gold (Au), copper (Cu), molybdenum (Mo), titanium (Ti), and tantalum (Ta), or alloys thereof.

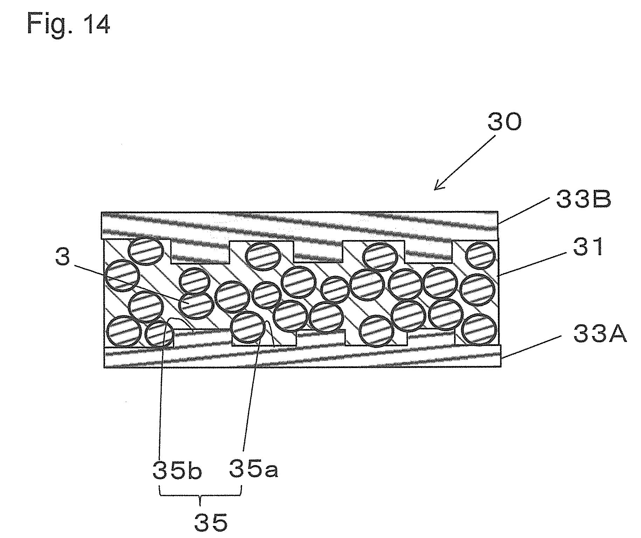

Fig. 14 is a cross-sectional schematic diagram illustrating a photoelectric conversion device of a fourth embodiment, in which the photoelectric conversion layer arranged between two current collection layers has the quantum dots. Both of the current collection layers 33A, 33B of a photoelectric conversion device 30 illustrated in Fig. 14 function as electrodes.

When the photoelectric conversion layer 31 is formed of a film having the stacked quantum dots 3, the protrusion quantum dots 3a are formed due to the rough film surface and are present so as to form the convex portions on the outermost surfaces of the quantum-dot-containing layer 5 of the photoelectric conversion layer 31, that is, the concave portions 35a are formed by the protrusion quantum dots 3a on the surfaces of the current collection layers 33A, 33B.

In such a structure, the protrusion quantum dots 3a can increase the absorbance of the photoelectric conversion layer 31. In addition, the current collection layers 33A, 33B, which have the concave portions 35a and the convex portions 35b, can enhance the taking-out efficiency of the carriers from the current collection layers 33A, 33B.

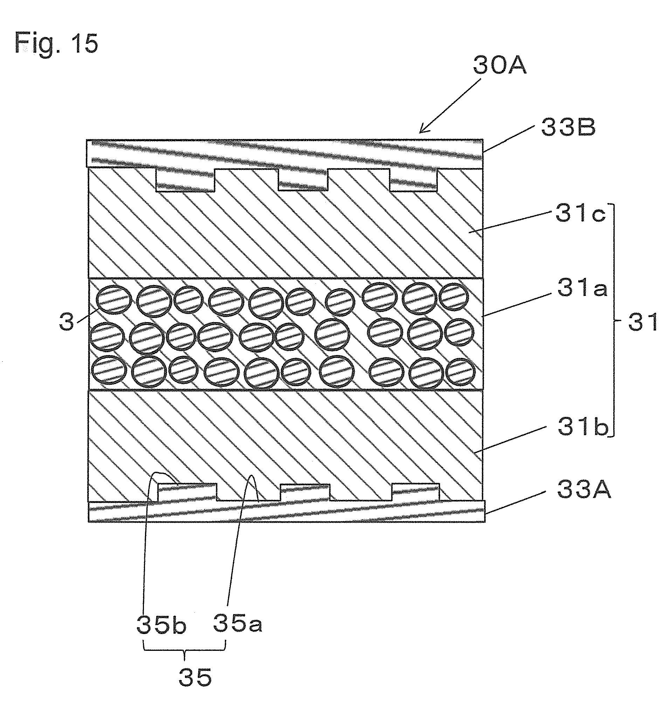

Fig. 15 is a cross-sectional schematic diagram illustrating a photoelectric conversion device of a fifth embodiment, in which the photoelectric conversion layer 31 arranged between two current collection layers 33A, 33B includes a p-type semiconductor layer as a second photoelectric conversion layer 31b on the lower face of a first photoelectric conversion layer 31a including the quantum dots 3, and an n-type semiconductor layer as a third photoelectric conversion layer 31c on the upper face of the first photoelectric conversion layer 31a including the quantum dots 3. In Figs. 14 and 15, only the quantum dots 3, in part, are illustrated.

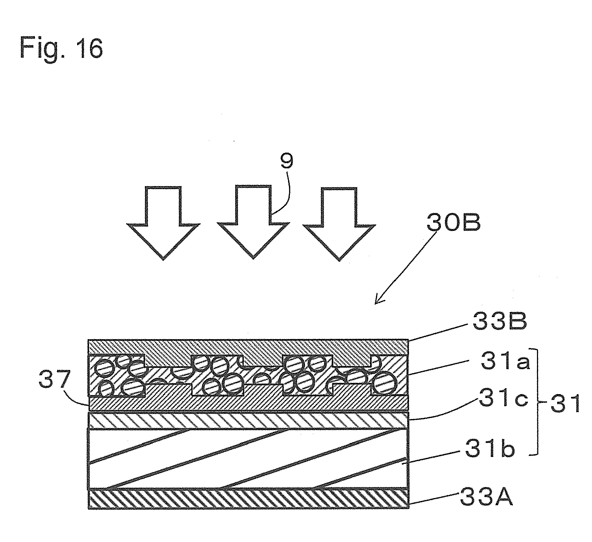

Fig. 16 is a cross-sectional schematic diagram illustrating a photoelectric conversion device of a sixth embodiment, in which the photoelectric conversion layer is sandwiched between a joining layer 37 having concave-convex portions and the n-side electrode 33B having concave-convex portions. As described above, in a photoelectric conversion device 30B, the photoelectric conversion layer 31 is sandwiched between the current collection layers 33A, 33B. In the photoelectric conversion device 30B, the first photoelectric conversion layer 31a is sandwiched between the current collection layer 33B and the joining layer 37, which have the concave-convex portions 35, and the n-type semiconductor layer (the third photoelectric conversion layer 31c), the p-type semiconductor layer (the second photoelectric conversion layer 31b), and the p-side electrode 33A are provided on the lower face side of the joining layer 37 in that order. In this case, the photoelectric conversion layer 31 includes the first photoelectric conversion layer 31a including the quantum dots 3, the second photoelectric conversion layer 31b including the p-type semiconductor layer, and the third photoelectric conversion layer 31c including the n-type semiconductor layer. As with the current collection layers 33A, 33B, the joining layer 37 has current collection properties.

In the photoelectric conversion device 30A of the fifth embodiment and the photoelectric conversion device 30B of the sixth embodiment, the photoelectric conversion layer 31 includes the first photoelectric conversion layer 31a having the quantum dots 3, in addition to the p-type semiconductor layer (the second photoelectric conversion layer 31b) and the n-type semiconductor layer (the third photoelectric conversion layer 31c), so that it is possible to absorb light in a wider wavelength region, as compared with the single joining photoelectric conversion device (solar cell) including the p-type semiconductor layer (the second photoelectric conversion layer 31b) and the n-type semiconductor layer (the third photoelectric conversion layer 31c).

For the photoelectric conversion device 30A illustrated in Fig. 15, the p-type semiconductor layer (the second photoelectric conversion layer 31b) may include the quantum dots 3 having the same polarity (p-type), and the n-type semiconductor layer (the third photoelectric conversion layer 31c) may include the quantum dots 3 having the same polarity (n-type). When the p-type semiconductor layer (the photoelectric conversion layer 31b) includes the quantum dots 3 having the same polarity and the n-type semiconductor layer (the photoelectric conversion layer 31c) includes the quantum dots 3 having the same polarity, the solar cell can widely absorb light having a wavelength on the higher energy side.

Further, for the photoelectric conversion device 30B illustrated in Fig. 16, the photoelectric conversion layer 31a preferably includes a combination of the p-type and n-type quantum dots 3 of the photoelectric conversion layer 31a, or a combination of the p-type, n-type, and i-type quantum dots 3 of the photoelectric conversion layer 31a. Such a structure can increase the electric charge separation properties of the photoelectric conversion layer 31a, thereby further enhancing the current collection efficiency of the carriers.

For the photoelectric conversion device 30A illustrated in Fig. 15 and the photoelectric conversion device 30B illustrated in Fig. 16, the current collection layers 33A, 33B and the joining layer 37 preferably have the concave portions 35a engaging with the photoelectric conversion layer 31 and have a chevron-shaped cross section.

Here, the quantum dots 3, 3a preferably have a substantial spherical body to be formed of composite particles P having a core-shell structure.

In this case, the photoelectric conversion layer 31a preferably includes the p-type, i-type, and n-type photoelectric conversion layers, which are laminated in that order. As the second photoelectric conversion layer 31b including the p-type semiconductor, preferable is the semiconductor material doped with an element having a higher valence than the elements of groups 12 to 16 in the periodic table (e.g., Ga, In, Si, Ge, P, and As). As the third photoelectric conversion layer 31c including the n-type semiconductor, preferable is the semiconductor material doped with an element having a lower valence than the elements of groups 12 to 16 in the periodic table.

A method for manufacturing the photoelectric conversion device of the fourth embodiment in Fig. 14 will be described.

First, the current collection layer 33A is formed on the surface of one substrate selected from plastic, glass, ceramic, and semiconductor substrates by using a physical thin-film forming method, such as sputtering, molecular beam epitaxy, and laser ablation, or coating a conductor paste for baking.

At this time, when the current collection layer 33A having, on its surface, the concave-convex portions 35 is formed by the physical thin-film forming method, a metal film is formed on substantially the entire principal surface of the substrate to form a base current collection layer as a first layer. Then, a mask in which the portions that become the convex portions 35b are opened is provided on the upper side of the base current collection layer to perform film forming again. A metal film as a second layer becomes the convex portions 35b.

When the current collection layer 33A is formed by using a conductor paste, a screen that can form a print film that is solid on the entire surface thereof and a screen in which only the portions corresponding to the convex portions 35b are opened are printed sequentially. In this case, portions having different aperture rates are provided in one of the screens so as to become the portion that is solid on the entire surface and the portions corresponding to the convex portions 35b. This makes it possible to form the current collection layer 33A having the concave-convex portions 35 by one printing.

The semiconductor film that becomes the photoelectric conversion layer 31 is formed on the surface of the current collection layer 33A. In this case, the semiconductor film is formed by using the same physical thin-film forming method or printing method as the current collection layer 33A. To form the photoelectric conversion layer 31 into a three-layer structure of the p-type, the i-type, and the n-type, a semiconductor material in which a component having a different valence is doped into each of the p-type layer and the n-type layer is applied, and is not doped into the i-type semiconductor.

To form the photoelectric conversion layer 31 from composite particles P having a core-shell structure, composite particles P having a core-shell structure are previously made, a slurry containing composite particles P is prepared, the substrate formed with the current collection layer 33A is immersed into the slurry and is pulled up, and the semiconductor film is stacked and formed on the surface of the current collection layer 33A. In this case, composite particles P are arranged so as to form the convex portions on the outermost surface of the photoelectric conversion layer 31. When the current collection layer 33 is formed on the surface, the concave portions 35a are formed on the surface of the current collection layer 33B formed on the upper surface of the photoelectric conversion layer 31.

The laminate formed with the semiconductor film that becomes the photoelectric conversion layer 31 is heated to a temperature of 300°C to 600°C in an inert gas, such as argon or nitrogen, or in a reducing gas containing hydrogen. Thus, the joining of the current collection layer 33A and the photoelectric conversion layer 31 can be stronger. The photoelectric conversion layer 31 is along the surface shape of the current collection layer 33A.

Thereafter, the current collection layer 33B is formed by the same method as the current collection layer 33A to obtain the photoelectric conversion device 30 illustrated in Fig. 14.

Composite particles P having a core-shell structure are formed by precipitating a metal component by biomineralization from the solution of the metal compound containing the semiconductor material.

Thus, in the obtained photoelectric conversion devices 30, 30A, and 30B (solar cells), the current collection layers 33A, 33B in contact with the photoelectric conversion layers 31, 31a have the concave-convex portions 35. This makes it possible to enhance the taking-out efficiency, from the current collection layers 33A, 33B, of the carriers, such as halls h, generated in the photoelectric conversion layers 31 (Fig. 14) and 31a (Figs. 15, 16), thereby improving power generation efficiency.

To make the photoelectric conversion device 30A of the fifth embodiment in Fig. 15, the current collection layer 33A that becomes the p-side electrode is formed on the surface of the substrate. Then, the photoelectric conversion layers 31b, 31a, and 31c are formed. Finally, the current collection layer 33B that becomes the n-side electrode is formed on the surface of the photoelectric conversion layer 31c that is the n-type semiconductor layer.

To make the photoelectric conversion device 30B of the sixth embodiment, formed is the laminate including the current collection layer 33A that becomes the p-side electrode, the p-type semiconductor layer (the second photoelectric conversion layer 31b), and the n-type semiconductor layer (the third photoelectric conversion layer 31c). Then, the joining layer 37 is formed on the surface of the n-type semiconductor layer (the third photoelectric conversion layer 31c). Subsequently, the first photoelectric conversion layer 31a is formed on the surface of the joining layer 37. Finally, the current collection layer 33B that becomes the n-side electrode is formed.

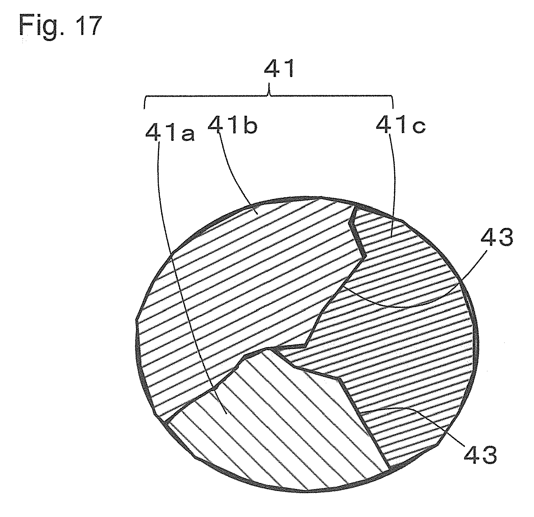

Fig. 17 is a cross-sectional view illustrating a quantum dot of another embodiment. In the above description of the photoelectric conversion layers 1, 21, and 31 and the photoelectric conversion devices 10, 20, and 30 of the first to sixth embodiments, single crystals or high-crystalline semiconductor nanoparticles similar thereto are typically preferable for the quantum dots 3, 3a of the photoelectric conversion layers 1, 21, and 31. However, the present invention is not limited to this, and the quantum dots may be a polycrystal particle 41 having a plurality of domains 41a, 41b, and 41c.

Even when the quantum dots 3, 3a are a polycrystal, the domains 41a, 41b, and 41c are a single crystal and are isolated from each other, with grain boundaries 43 as intermediate layers. This makes it possible to exhibit the characteristic of the quantum dots 3, 3a.

Here, in the polycrystal particle 41 having the domains 41a, 41b, and 41c, two or more crystals are present in each of the semiconductor nanoparticles (the quantum dots 3, 3a) via the grain boundaries 43 formed due to dislocation and defect. In this case, the domains 41a, 41b, and 41c are a single crystal.

The quantum dots 3, 3a formed of such a polycrystal particle 41 may be complexed to the quantum dots 3, 3a including a single crystal of substantially the same size as the polycrystal particle 41.

Even when the quantum dots 3, 3a having such a form have a large particle diameter, the quantum dots 3, 3a have the quantum effect by the domains 41a, 41b, and 41c. Thus, the outer shape of the quantum dots 3, 3a is not limited to a spherical shape, and may be any one of a cylindrical shape and a polygonal shape. In addition, the quantum dots 3, 3a having a spherical shape, a cylindrical shape, and a polygonal shape together, may be used so as to be suitable for mass production.

### REFERENCE SIGNS LIST

1, 21, 21a, 21b, 21c, 31 Photoelectric conversion layer
3 Quantum dot
3a Protrusion quantum dot
4 Wall section
5 Quantum-dot-containing layer
5a Base portion
7 Surface (of quantum-dot-containing layer)
9, 113 Light (solar light)
10, 20, 30, 30A, 30B Photoelectric conversion device
11, 101 Substrate
13a, 24a, 103 p-side electrode
13b, 24b, 111 n-side electrode
15, 25, 105 First semiconductor layer
17, 107 Optical sensing layer
18, 26, 109 Second semiconductor layer
19, 27, 37 Joining layer
33, 33A, 33B Current collection layer
33a Surface (of current collection layer)
35 Concave-convex portion
35a Concave portion
35b Convex portion
C Core
P Composite particle
S Shell
H Void
e Electron
h Hall
L Straight line

## Claims

1. A photoelectric conversion layer comprising a quantum-dot-containing layer, the quantum-dot-containing layer having a plurality of quantum dots and wall sections enclosing the quantum dots, wherein in the cross section in the thickness direction of the quantum-dot-containing layer, the quantum dots are aligned along a surface of the quantum-dot-containing layer so as to be adjacent to each other, and when three quantum dots adjacent to each other are extracted to draw a straight line so as to connect the surface side ends of the two quantum dots located on both sides, the quantum dot located in the middle protrudes from the straight line to the surface side by an amount equal to at least half the diameter of the quantum dot located in the middle, the quantum dot located in the middle being a protrusion quantum dot.

2. The photoelectric conversion layer according to claim 1, wherein when the surface of the quantum-dot-containing layer is seen in planar view, the protrusion quantum dots are arranged so as to be spaced from each other.

3. The photoelectric conversion layer according to claim 1 or 2, wherein the quantum dots and the protrusion quantum dots of the quantum-dot-containing layer have the same main component.

4. The photoelectric conversion layer according to any one of claims 1 to 3, wherein when the surface of the quantum-dot-containing layer is seen in planar view, the protrusion quantum dots are aligned in a curved shape.

5. The photoelectric conversion layer according to any one of claims 1 to 4, wherein the quantum dots and the protrusion quantum dots of the quantum-dot-containing layer are covered by the wall sections, the quantum dots and the wall sections and the protrusion quantum dots and the wall sections forming core-shell composite particles.

6. The photoelectric conversion layer according to any one of claims 1 to 5, wherein the quantum dots of the quantum-dot-containing layer are bonded to each other by the van der Waals force.

7. The photoelectric conversion layer according to any one of claims 1 to 6, further comprising a void between the quantum dots of the quantum-dot-containing layer.

8. The photoelectric conversion layer according to any one of claims 1 to 7, wherein the quantum dots of the quantum-dot-containing layer have an average particle diameter different in the thickness direction of the quantum-dot-containing layer.

9. The photoelectric conversion layer according to claim 8, wherein the quantum-dot-containing layer has, in the thickness direction thereof, an upper layer, a middle layer, and a lower layer, the upper layer and the lower layer having a smaller average particle diameter than the middle layer.

10. A photoelectric conversion device comprising an optical sensing layer having the photoelectric conversion layer according to any one of claims 1 to 9.

11. The photoelectric conversion device according to claim 10, wherein the optical sensing layer further comprises a first semiconductor layer, and a second semiconductor layer.

12. The photoelectric conversion device according to claim 10 or 11, wherein the quantum-dot-containing layer has a quantum-dot-containing layer having p-type quantum dots, and a quantum-dot-containing layer having n-type quantum dots.

13. The photoelectric conversion device according to any one of claims 10 to 12, wherein the photoelectric conversion layer is provided so that the protrusion quantum dots are located on the incidence light side.

14. The photoelectric conversion device according to any one of claims 10 to 13, wherein the optical sensing layer includes a current collection layer arranged on the surface of the photoelectric conversion layer, the current collection layer having concave portions and convex portions on the surface on the photoelectric conversion layer side.

15. The photoelectric conversion device according to claim 14, wherein the convex portions have a chevron-shaped cross section in the thickness direction of the current collection layer.

16. The photoelectric conversion device according to claim 14 or 15, wherein the convex portions are aligned in a curved shape, when the current collection layer is seen in planar view from the photoelectric conversion layer side.

17. The photoelectric conversion device according to any one of claims 14 to 16, wherein the concave portions of the current collection layer are arranged so as to engage with the protrusion quantum dots of the photoelectric conversion layer.

18. The photoelectric conversion device according to any one of claims 14 to 17, wherein the current collection layers are arranged so as to sandwich the photoelectric conversion layer therebetween.
